**Europäisches Patentamt**

**European Patent Office**

**Office européen des brevets**

(19)

(11) Veröffentlichungsnummer: **0 008 043**
**B1**

(12) **EUROPÄISCHE PATENTSCHRIFT**

(45) Veröffentlichungstag der Patentschrift:
05.05.82

(21) Anmeldenummer: **79102670.1**

(22) Anmeldetag: **26.07.79**

(51) Int. Cl.³: **H 01 L 27/02,** H 01 L 29/10 //
H01L21/82, H03K19/08

(54) **Integrierter bipolarer Halbleiterschaltkreis.**

(30) Priorität: **11.08.78 DE 2835330**

(43) Veröffentlichungstag der Anmeldung:
**20.02.80 Patentblatt 80/4**

(45) Bekanntmachung des Hinweises auf die Patenterteilung:
**05.05.82 Patentblatt 82/18**

(84) Benannte Vertragsstaaten:
**FR GB IT**

(56) Entgegenhaltungen:
**DE–A–2 455 347**
**DE–A–2 538 326**
**DE–A–2 655 400**
**DE–A–2 800 240**
**FR–A–2 319 197**
**FR–A–2 336 798**

(73) Patentinhaber: **SIEMENS AKTIENGESELLSCHAFT Berlin und München, Postfach 22 02 61, D-8000 München 22 (DE)**

(72) Erfinder: **Häfen, Günter Von, Dr.,Dipl.-Phys, Josef-Mohr-Weg 57, D-8000 München 83 (DE)**

Integrierter bipolarer Halbleiterschaltkreis.

Die vorliegende Erfindung betrifft einen integrierten bipolaren Halbleiterschaltkreis gemäss dem ersten Teil des Anspruchs 1.

Insbesondere für integrierte bipolare Schaltkreise, in denen neben genauen Analogschaltungen für Betriebsspannungen >30 V grössere Digitalschaltungen benötigt werden, müssen npn-Transistoren mit grosser Kollektor-Emitter-Durchbruchspannung $U_{CEO} > 30$ V und pnp-Transistoren mit genügend grossen Aufwärtsstromverstärkungen, welche in der Regel als $I^2L$-Transistoren arbeiten, hergestellt werden können. Generell kann es nicht nur in Analogschaltungen, sondern auch in Digitalschaltungen notwendig sein, Transistoren mit hoher Durchbruchspannung zur Verfügung zu haben.

Eines der Hauptprobleme bei integrierten bipolaren Schaltkreisen mit zwei verschiedenen Transistortypen der vorgenannten Art besteht darin, unabhängige Steuermöglichkeiten für die Stromverstärkung der Transistoren für hohe Durchbruchspannung einerseits und für die Aufwärtsstromverstärkung anderseits zu realisieren.

Es ist bereits auf verschiedene Weise versucht worden, integrierte bipolare Schaltkreise mit derartigen Transistor-Kombinationen zu schaffen.

Will man bei der Herstellung der beiden Transistorarten in der üblichen Planartechnik ohne zusätzliche Verfahrensschritte auskommen, so ist nur eine Art von npn-Transistoren realisierbar, die in einem Teil des bipolaren integrierten Schaltkreises abwärts und im anderen Teil des Schaltkreises aufwärts betrieben werden. Unter Abwärtsbetrieb ist hier zu verstehen, dass beim üblichen Aufbau von Transistoren nach dem Planarprozess die Zonenfolge Emitter-Basis-Kollektor derart in einer auf einem Substrat befindlichen epitaktischen Schicht liegt, dass der Emitter an der freien Oberfläche der epitaktischen Schicht liegt und sich Basis und Kollektor nach innen in die epitaktische Schicht fortsetzen, wobei der Kollektor durch die epitaktische Schicht selbst gebildet wird. Anderseits ist unter Aufwärtsbetrieb zu verstehen, dass sich diese Zonenfolge umkehrt, d.h. der Kollektor liegt an der freien Oberflächenseite der epitaktischen Schicht, während der Emitter durch die epitaktische Schicht selbst gebildet wird.

Will man, wie vorstehend erwähnt, bei der Herstellung beider Transistorarten ohne zusätzliche Verfahrensschritte auskommen, so sind für Durchbruchspannungen $U_{CEO} > 30$ V der abwärts betriebenen npn-Transistoren Höchstwerte für die Leitfähigkeit und Mindestwerte für die Dicke der epitaktischen Schicht zu beachten. Im Gegensatz dazu ist für die Stromverstärkung im Aufwärtsbetrieb eine möglichst hochdotierte und möglichst dünne epitaktische Schicht anzustreben. Beispielsweise aus der Druckschrift «IEEE J. Sol. St. Circuits», SC–11, Nr. 4 (1976), Seite 478 bekanntgewordene Versuche führen zu einem Kompromiss, mit dem noch für Gatter mit einer Ausgangsverzweigung von 3 die unbedingt notwendige Aufwärtsstromverstärkung und für Analogschaltungen eine Durchbruchspannung von maximal 30 V im Abwärtsbetrieb realisierbar sind.

In der Praxis bedeutet dieser Kompromiss jedoch eine Ausbeuteverminderung, da unvermeidbare Streuungen im Herstellungsgang dazu führen, dass die angestrebten Werte nur selten gleichzeitig erzielt werden.

Insbesondere für grössere Durchbruchspannungen von >30 V ist es notwendig, zusätzliche Verfahrensschritte einzuführen. Gemäss bisher bekanntgewordenen Versuchen zielen diese Verfahrensschritte darauf ab, in integrierten bipolaren Schaltkreisen nebeneinander unterschiedliche aufgebaute npn-Transistoren herzustellen, welche die beiden verschiedenen Anforderungen erfüllen.

Bei einer Gruppe von Verfahren wird eine lokale Erhöhung der Dotierungskonzentration der epitaktischen Schicht in Betracht gezogen. Derartige Verfahren sind beispielsweise in der Druckschrift «Technical Digest IEDM», Dez. 1977, Seite 175, beschrieben. Bei diesen Verfahren ergeben sich Transistoren mit verringerter Basisweite und damit erhöhter Toleranzempfindlichkeit bei der Emitterdiffusion. Die Stromverstärkungen beider Transistorarten können darüber hinaus nicht getrennt eingestellt werden.

Bei einem weiteren aus «Digest Technical Paper ESCIRC», Sept. 1977/Ulm, Seiten 20–22, bekannt gewordenen Verfahren wird eine zusätzliche Emitterschicht eindiffundiert, welche zu Transistoren mit hoher Abwärtsstromverstärkung und folglich genügend hoher Aufwärtsstromverstärkung führt. Die Basisweite dieser Transistoren ist jedoch sehr gering, wobei auch die Steuerung und Einhaltung der Stromverstärkung sehr schwierig ist.

Es ist weiterhin auch bekannt geworden, im Schaltungsteil mit aufwärts betriebenen Transistoren eine schwächer dotierte Basisschicht dadurch herzustellen, dass eine Bor-Implantation für die Basis durch eine Oxidschicht durchgeführt wird, die einen Teil der implantierten Dosis absorbiert. Dies führt sowohl zu geringen Basisweiten als auch zu einer kritischen Abhängigkeit der Stromverstärkung von der Oxidschichtdicke.

Den vorstehend erläuterten Verfahren ist gemeinsam, dass sie auf der Verwendung einer dünnen, schwach dotierten Basis beruhen. Daher liegt die sogenannte punch-through-Spannung (das ist diejenige Spannung, bei der die Raumladungszonen der pn-Übergänge des Transistors zusammenwachsen) sehr niedrig, beispielsweise im Bereich von 2 bis 5 V. Die Stromverstärkung im Schaltungsteil mit aufwärtsbetriebenen Transistoren ist dabei sehr schwierig zu steuern und erheblichen Streuungen unterworfen. Ausserdem ist bei geringer Basisweite die Ausfallwahrscheinlichkeit aufgrund von durch Kristallfehler bedingten Kollektor-Emitter-Kurzschlüssen (sogenannten Pipes) grösser.

Der vorliegenden Erfindung liegt die Aufgabe zugrunde, bipolare integrierte Schaltkreise der in Rede stehenden Art in einer gegenüber dem Stand der Technik vereinfachten Herstellungsart mit unabhängig einstellbarer Durchbruchspannung und Aufwärtsstromverstärkung mit an die Schaltungsbedürfnisse anpassbaren Grössen anzugeben.

Diese Aufgabe wird bei einem integrierten bipolaren Halbleiterschaltkreis der eingangs genannten Art dadurch gelöst, dass die epitaktische Schicht eine durchgehend gleiche Dicke besitzt.

Für die Herstellung erfindungsgemässer bipolarer Halbleiterschaltkreise ist gegenüber der Herstellung beider Transistorarten mit den gleichen Prozessschritten lediglich eine zusätzliche Maske, ein zusätzlicher Fototechnikschritt sowie ein zusätzlicher Dotierungsschritt erforderlich.

Die Stromverstärkung der Transistoren mit grosser Aufwärtsstromverstärkung wird nahezu ausschliesslich von deren gesondert hergestellten Besiszonen bestimmt. Durch die grössere Tiefe dieser Basiszonen wird die Stromverstärkung in einem Schaltungsteil mit Transistoren grosser Aufwärtsstromverstärkung nahezu unabhängig von der Herstellung der Emitter in einem Schaltungsteil mit Transistoren grosser Durchbruchspannung. Die Steuerung der Stromverstärkung in diesem Schaltungsteil kann in üblicher Weise über die Emitterdiffusionsdauer ohne Rücksicht auf den Schaltungsteil mit Transistoren grosser Aufwärtsstromverstärkung erfolgen. Die Stromverstärkung im Schaltungsteil mit Transistoren grosser Aufwärtsstromverstärkung wird über den Schichtwiderstand und die Diffusionszeit der Basiszonen für diese Transistoren eingestellt. Diese Parameter beeinflussen die Stromverstärkung im Schaltungsteil mit Transistoren grosser Durchbruchspannung in keiner Weise.

Dadurch wird erreicht, dass neben einem in den Daten völlig ungeänderten Schaltungsteil mit Transistoren grosser Durchbruchspannung ein Schaltungsteil mit Transistoren grosser Aufwärtsstromverstärkung toleranz-unempfindlich hergestellt werden kann.

Darüber hinaus weisen die Transistoren mit grosser Aufwärtsstromverstärkung zwei weitere wesentliche Vorteile auf. Erstens ist die punchthrough-Spannung wegen der grossen Basisweite der Transistoren mit grosser Stromverstärkung hoch und damit ein unkritischer Parameter für einen diese Transistoren enthaltenden Schaltungsteil. Zweitens ist aus dem gleichen Grund die Ausfallwahrscheinlichkeit aufgrund von durch Kristallfehler bedingten Kollektor-Emitter-Kurzschlüssen (Pipes) erheblich verringert.

Weitere Ausgestaltungen des erfindungsgemässen bipolaren Halbleiterschaltkreises sind in Unteransprüchen gekennzeichnet.

Die Erfindung wird im folgenden anhand von in den Figuren der Zeichnung dargestellten Ausführungsbeispielen näher erläutert.

Es zeigt:

Fig. 1 einen Schnitt eines erfindungsgemässen bipolaren Halbleiterschaltkreises in einer Ebene I–I in Fig. 2,

Fig. 2 eine Draufsicht eines Teils des integrierten bipolaren Halbleiterschaltkreises nach Fig. 1,

Fig. 3 einen Schnitt eines erfindungsgemässen integrierten bipolaren Halbleiterschaltkreises, aus dem insbesondere Kontaktzonen für Basiszonen von Transistoren mit grosser Aufwärtsstromverstärkung ersichtlich sind,

Fig. 4 eine Ausführungsform mit einer einzigen Basiszone für mehrere Kollektoren von Transistoren grosser Aufwärtsstromverstärkung,

Fig. 5 eine weitere Ausführungsform mit jeweils einer Basiszone für jeweils einen Kollektor eines Transistors grosser Aufwärtsstromverstärkung und

Fig. 6 eine der Fig. 4 entsprechende Darstellung, aus der eine spezielle Ausgestaltung eines Injektors für als I²L-Transistoren arbeitende Transistoren grosser Aufwärtsstromverstärkung ersichtlich ist.

Vor einer ins einzelne gehenden Erläuterung der in den Figuren der Zeichnung dargestellten Ausführungsbeispiele sei zunächst darauf hingewiesen, dass es sich lediglich um schematische Darstellungen handelt, anhand derer das wesentliche der Erfindung jedoch ausreichend klar erläutert werden kann. Insbesondere erheben die Figuren beispielsweise keinen Anspruch auf Massstabsgenauigkeit oder etwa eine genaue Darstellung des Verlaufs von Dotierungsfronten.

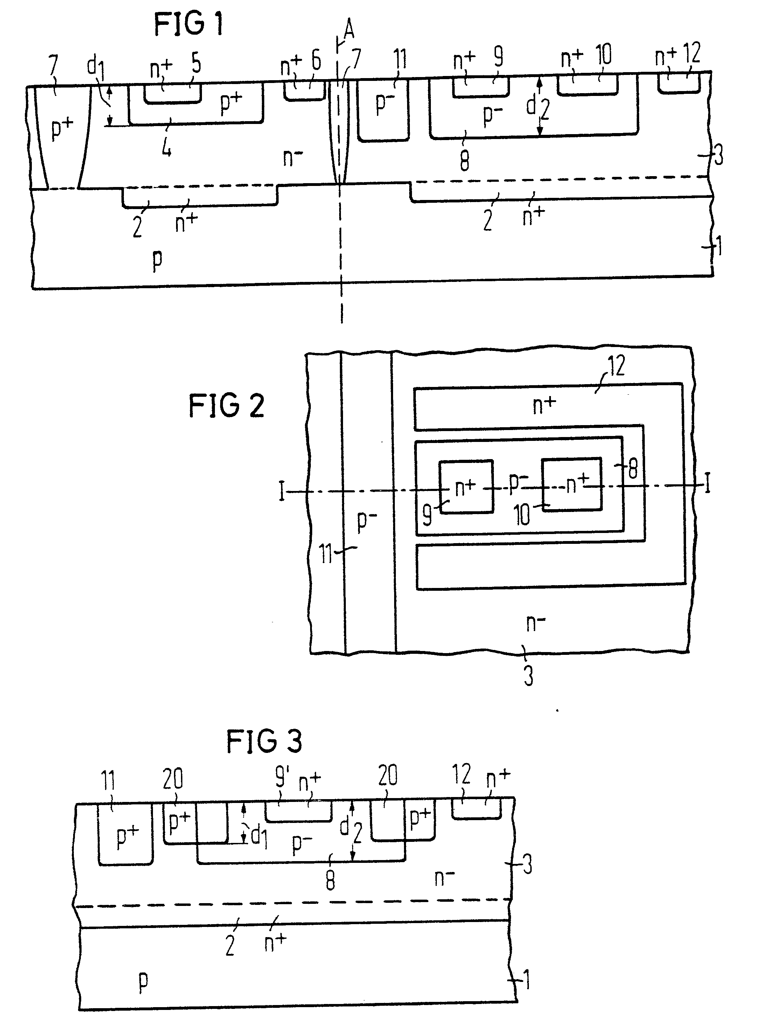

Gemäss den Fig. 1 und 2, an denen auch das Herstellungsverfahren erläutert werden kann, bildet ein beispielsweise p-dotiertes Substrat 1 die Grundlage für einen erfindungsgemässen integrierten bipolaren Halbleiterschaltkreis. In dieses Substrat sind in an sich bekannter Weise buried-layer-Zonen 2 eindiffundiert, die im vorliegenden Ausführungsbeispiel hochdotierte n$^+$-Zonen sind. Auf das die buried-layer-Zonen 2 enthaltende Substrat 1 wird ebenfalls in an sich bekannter Weise eine epitaktische Schicht 3 aufgebracht, welche im vorliegenden Ausführungsbeispiel eine schwachdotierte n$^-$-Schicht ist. Bei einem praktischen Ausführungsbeispiel kann das Substrat 1 beispielsweise einen spezifischen Widerstand von 8 Ohm · cm und die epitaktische Schicht 3 bei einer Dicke von 10 µm einen spezifischen Widerstand von 3 Ohm · cm besitzen.

Durch eine maskierte Diffusion werden in der epitaktischen Schicht hochdotierte Isolationsrahmen hergestellt, von denen in Fig. 1 zwei hochdotierte p$^+$-Zonen 7 dargestellt sind.

Darauffolgend werden in der epitaktischen Schicht 3 oberhalb von buried-layer-Zonen 2 Basiszonen 8 für Transistoren grosser Aufwärtsstromverstärkung hergestellt. Diese Basiszonen sind im Ausführungsbeispiel nach den Fig. 1 und 2 schwachdotierte p$^-$-Zonen. Die Einbringung der Dotierung für diese Basiszonen 8 kann durch Diffusion oder – wegen der erzielbaren grösseren Genauigkeit – vorzugsweise durch Ionenimplantation mit Bor erfolgen. Ein Diffusionsprozess erfolgt dabei in üblicher Weise durch Maskierung, Belegung und Eindiffusion.

Die in Fig. 1 mit d bezeichnete Eindringtiefe der Basiszonen 8 (Tiefe in Richtung der Zonenfolge Emitter-Basis-Kollektor) kann beispielsweise zwischen 26 µm liegen, während der Schichtwiderstand dieser Basiszonen beispielsweise zwischen 500 Ohm und 20 kOhm liegen kann.

Der weitere Herstellungsgang läuft in der in der Planartechnik üblichen Weise ab. In einem nächstfolgenden Schritt wird die Maskierung und Diffusion von Basiszonen 4 für Transistoren grosser Durchbruchspannung hergestellt, wobei eine in Fig. 1 mit $d_1$ bezeichnete Eindringtiefe dieser Basiszonen kleiner als die Eindringtiefe $d_2$ der Basiszonen für Transistoren mit grosser Aufwärtsstromverstärkung ist. Die Eindringtiefe $d_1$ der Basiszonen 4 für Transistoren grosser Durchbruchspannung beträgt beispielsweise 1,5–3,5 µm, während ihr Schichtwiderstand beispielsweise 150 Ohm beträgt. Gleichzeitig mit der Herstellung der Basiszonen 8 können auch Injektoren 11 für Transistoren mit grosser Aufwärtsstromverstärkung hergestellt werden, wenn diese als $I_2L$-Transistoren betrieben werden. Die Eindringtiefe dieser als Injektoren wirkenden $p^-$-Zonen 11 entspricht dabei der Eindringtiefe der Basiszonen 8 von Transistoren grosser Aufwärtsstromverstärkung.

Im weiteren Herstellungsgang werden sodann nach entsprechender Maskierung in die Basiszonen 4 für Transistoren grosser Durchbruchspannung Emitterzonen 5 ($n^+$-Zonen) und in die epitaktische Schicht 3 Kollektoranschlüsse 6 ($n^+$-Zonen) für die Transistoren grosser Durchbruchspannung sowie ein an sich bekannter sogenannter Kragen 12 ($^+$-Zone) für Transistoren grosser Aufwärtsstromverstärkung hergestellt. Der letztgenannte Kragen 12 bewirkt einen weiteren Anstieg der Aufwärtsstromverstärkung sowie eine Entkopplung von Gattern, wenn jeweils mehrere Transistoren grosser Aufwärtsstromverstärkung in einem Digitalteil des integrierten bipolaren Halbleiterschaltkreises als Gatter betrieben werden.

Im Ausführungsbeispiel nach den Fig. 1 und 2 sind zwei Transistoren grosser Aufwärtsstromverstärkung dargestellt, welche durch einen Kragen 12 umgeben werden. Als Kollektoren wirkende Zonen 9 und 10 ($n^+$-Zonen) werden gleichzeitig mit der Herstellung der Emitter 5 und der Kollektoranschlüsse 6 für Transistoren grosser Durchbruchspannung sowie dem Kragen 12 hergestellt.

Bei einem integrierten bipolaren Halbleiterschaltkreis der vorstehend erläuterten Art sind beispielsweise npn-Transistoren mit den folgenden Parametern realisierbar:

npn-Transistoren mit hoher Durchbruchspannung besitzen bei einem Kollektorstrom $I_C = 1mA$ eine Kollektor-Emitter-Durchbruchspannung $U_{CEO} > 36$ V und eine Stromverstärkung B von $60 < B < 250$. npn-Transistoren grosser Aufwärtsstromverstärkung besitzen bei Herstellung ihrer Basis durch Implantation mit einer Implantationsbelegung $Q = 6 \times 10^{12}$ $B^+/cm^2$ eine Aufwärtsstromverstärkung von 20 bei einem Kollektorstrom $I_C$ von 100 µmA.

Der Vollständigkeit halber sei erwähnt, dass die Kontaktierung und die Verbindung der einzelnen Funktionseinheiten durch Leiterbahnen in der in der integrierten Schaltkreistechnik üblichen Weise erfolgt. Auf eine ins einzelne gehende Darstellung dieser Prozessschritte kann daher verzichtet werden.

Aus der Darstellung nach Fig. 3 ist ersichtlich, dass die Basisdiffusion zur Herstellung der Basis 4 für Transistoren grosser Durchbruchspannung (siehe Fig. 1 und 2) auch gleichzeitig zur Herstellung von Kontaktzonen für die Basiszonen 8 von Transistoren grosser Aufwärtsstromverstärkung ausgenutzt werden kann. Durch maskierte Diffusion ergeben sich dabei Kontaktzonen 20 ($p^+$-Zonen) der Tiefe $d_1$, welche mindestens den äusseren Rand der Basiszonen 8 überlappen. In Fig. 3 ist dabei lediglich ein einziger Transistor mit grosser Aufwärtsstromverstärkung dargestellt, der bei Betrieb als $I^2L$-Transistor eine einzige als Kollektor wirkende $n^+$-Zone 9' besitzt. Aus Übersichtlichkeitsgründen ist ein Transistor grosser Durchbruchspannung in Fig. 3 nicht dargestellt. Ein solcher Transistor entspricht vollständig der Ausführungsform nach Fig. 1.

Hinsichtlich der Transistoren grosser Aufwärtsstromverstärkung können für mehrere Transistoren entweder eine mehreren Transistoren gemeinsame Basis 8 oder für jeweils einen Transistor jeweils eine Basis 8 bzw. 8' vorgesehen werden.

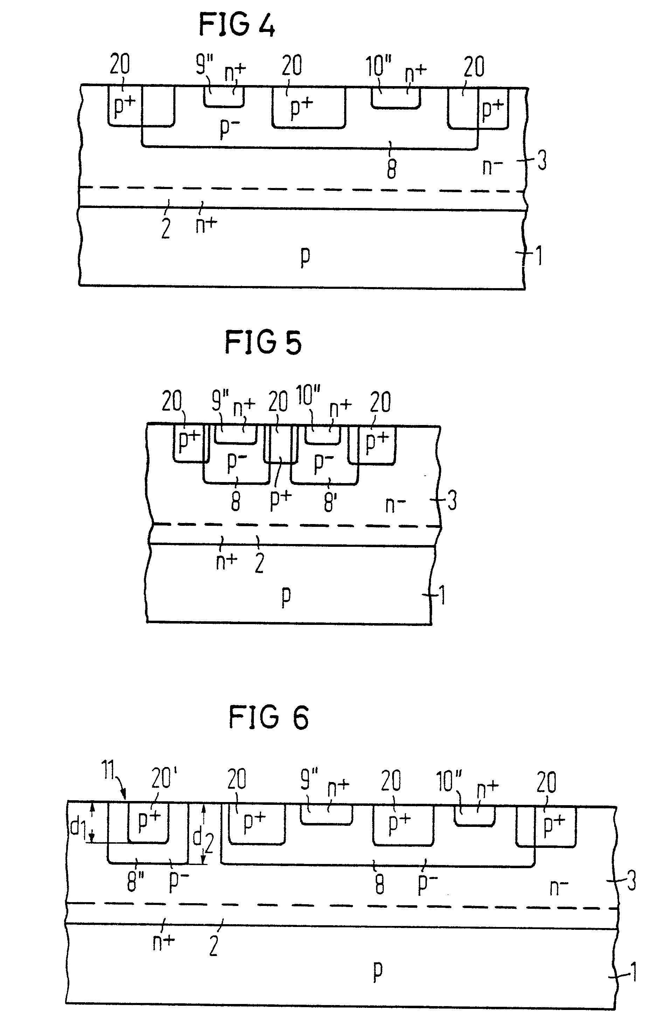

Eine Ausführungsform für den erstgenannten Fall ist in Fig. 4 dargestellt, in der eine einzige Basiszone 8 zwei bei Betrieb als $I_2L$-Transistoren als Kollektoren wirkende $n^+$-Zonen 9" und 10" sowie die entsprechenden Kontaktzonen 20 enthält. Die Basis 8 bildet dabei unter den Kollektoren 9" und 10" ein einfach zusammenhängendes Gebiet.

Eine Ausführungsform mit jeweils einer Basiszone 8 bzw. 8' für jeweils einen Transistor grosser Aufwärtsstromverstärkung ist in Fig. 5 dargestellt. Die bei Betrieb als $I^2L$-Transistoren als Kollektoren wirkenden $n^+$-Zonen 9" und 10" sind dabei in jeweils einer Basiszone angeordnet. Die Basiszonen 8 bzw. 8' sind dabei in einer lateralen Ebene senkrecht zur Richtung der Zonenfolge Emitter-Basis-Kollektor insbesondere nur wenig grösser als die Breite der in den Basiszonen angeordneten Zonen 9" und 10". Damit wird eine Layout-Automatisierung möglich und es kann weiterhin Einfluss auf die Aufwärtsstromverstärkung und die dynamischen Eigenschaften genommen werden.

Fig. 6 zeigt eine spezielle Ausgestaltung eines Injektors 11 für Transistoren grosser Aufwärtsstromverstärkung, deren Ausgestaltung hier entsprechend Fig. 4 dargestellt ist. Für die Herstellung dieses Injektors 11 werden die Herstellungsschritte sowohl für die Basiszonen 8 der Transistoren grosser Aufwärtsstromverstärkung als auch der Basiszonen 4 grosser Durchbruchspannung ausgenutzt. Dabei entsteht eine Zonenfolge mit einer ersten Zone 8″ der Tiefe $d_2$ entsprechend der Tiefe der Basiszone 8 für Transistoren grosser Aufwärtsstromverstärkung sowie mit einer zweiten Zone 20′ mit einer Tiefe $d_1$ entsprechend der Tiefe der Basiszonen 4 für Transistoren grosser Durchbruchspannung.

Es sei bemerkt, dass die vorstehend anhand der Ausführungsbeispiele beschriebenen Transistoren grosser Aufwärtsstromverstärkung nicht unbedingt als I²L-Transistoren, bei denen die Zonen 9 und 10 (siehe Fig. 1 und 2) als Kollektoren wirken, betrieben werden müssen. Diese Transistoren können vielmehr auch abwärts betrieben werden, wobei dann die Zonen 9 und 10 (Fig. 1 und 2) als Emitter arbeiten. Dabei ergibt sich der Vorteil einer hohen Abwärtsstromverstärkung für derart betriebene Transistoren.

Weiterhin bietet die Erfindung auch den Vorteil, dass die Basiszonen 8 bzw. 8′ der Transistoren hoher Aufwärtsstromverstärkung auch als hochohmige Widerstände oder im Zusammenwirken mit der epitaktischen Schicht 3 oder den Emitterzonen 5 als Dioden (insbesondere für Kapazitätsdioden geeignet) betrieben werden können.

### Patentansprüche

1. Integrierter bipolarer Halbleiterschaltkreis mit Transistoren grosser Durchbruchsspannung von vorzugsweise 30 V sowie Transistoren grosser Aufwärtsstromverstärkung, insbesondere I²L-Transistoren, bei dem in einer auf einem Halbleitersubstrat befindlichen epitaktischen Schicht (3) Basiszonen (8) der Transistoren grosser Aufwärtsstromverstärkung und Basiszonen (4) der Transistoren grosser Durchbruchsspannung derart ausgebildet sind, dass die Basiszonen (4) der Transistoren grosser Aufwärtsstromverstärkung im Vergleich zu den Basiszonen (8) der Transistoren grosser Durchbruchsspannung schwächer dotiert sind und von der freien Oberfläche der epitaktischen Schicht (3) gemessen eine grössere Tiefe besitzen, dadurch gekennzeichnet, dass die epitaktische Schicht (3) eine durchgehend gleiche Dicke besitzt.

2. Integrierter bipolarer Halbleiterschaltkreis nach Anspruch 1, dadurch gekennzeichnet, dass der Schichtwiderstand der Basiszonen (8, 8′) der Transistoren grosser Aufwärtsstromverstärkung zwischen etwa 500 Ohm bis 20 kOhm liegt.

3. Integrierter bipolarer Halbleiterschaltkreis nach Anspruch 1 und/oder 2, dadurch gekennzeichnet, dass die Tiefe ($d_2$) der Basiszonen (8, 8′) der Transistoren grosser Aufwärtsstromverstärkung zwischen etwa 2 und 6 µm liegt.

4. Integrierter bipolarer Halbleiterschaltkreis nach einem der Ansprüche 1–3, dadurch gekennzeichnet, dass die Tiefe ($d_1$) der Basiszonen (4) der Transistoren grosser Durchbruchspannung etwa 1,5–3,5 µm beträgt.

### Claims

1. An integrated bipolar semiconductor switching circuit comprising transistors having a high breakdown voltage of preferably 30 V, together with transistors of a high current gain, in particular I²-L-transistors, in which, in an epitaxial layer (3) arranged on a semiconductor substrate, base zones (8) of the high current gain transistors and base zones (4) of the transistors having a high breakdown voltage are formed in such a way that the base zones (4) of the high current gain transistors are less highly doped than the base zones (8) of the transistors having a high breakdown voltage, and have a greater depth measured from the exposed surface of the epitaxial layer (3), characterised in that the epitaxial layer (3) has a constant thickness.

2. An integrated bipolar semiconductor switching circuit as claimed in Claim 1, characterised in that the layer resistance of the base zones (8, 8′) of the high current gain transistors is in the range of about 5000 Ohm to 20 kOhm.

3. An integrated bipolar semiconductor switching circuit as claimed in Claim 1 and/or Claim 2, characterised in that the depth ($d_2$) of the base zones (8, 8′) of the high current gain transistors is in the range of about 2 to 6 µm.

4. An integrated bipolar semiconductor switching circuit as claimed in one of Claims 1 to 3, characterised in that the depth ($d_1$) of the base zones (4) of the transistors having a high breakdown voltage is about 1,5 to 3,5 µm.

### Revendications

1. Circuit de commutation intégré bipolaire et à semiconducteurs, à transistors à forte tension de rupture, de préférence de 30 V et à transistors à forte amplification de courant dans le sens ascendant (sens émetteur-collecteur), plus particulièrement à transistors I²L, du type dans lequel on forme, dans une couche épitaxiale (3) prévue sur un substrat semiconducteur, des zones de base (8) des transistors à forte amplification de courant dans le sens ascendant et des zones de base (4) des transistors à forte tension de rupture de telle manière que les zones de base (4) des transistors à forte amplification de courant dans le sens ascendant sont, par rapport aux zones de base (8) et des transistors à forte tension de rupture, plus faiblement dopés et ont une plus grande profondeur mesurée à partir de la surface libre de la couche épitaxiale (3), caractérisé par le fait que la couche épitaxiale (3) a une épaisseur constante sur toute son étendue.

2. Circuit de commutation intégré bipolaire et à semiconducteurs selon la revendication 1, caractérisé par le fait que la résistance de couches des zones de base (8, 8′) des transistors à forte amplification de courant dans le sens ascendant, se situe entre 530 Ohm à 20 kOhm environ.

3. Circuit de commutation intégré bipolaire et à semiconducteurs selon la revendication 1 et/ou 2, caractérisé par le fait que la profondeur ($d_2$) de la zone de base (8, 8') des transistors à forte amplification de courant dans le sens ascendant se situe entre environ 2–6 µm.

4. Circuit de commutation intégré bipolaire et à semiconducteurs selon l'une des revendications 1–3, caractérisé par le fait que la profondeur ($d_1$) des zones de base (4) des transistors à forte tension de rupture est d'environ 1,5–3,5 µm.

FIG 1

FIG 2

FIG 3

## FIG 4

## FIG 5

## FIG 6